**Europäisches Patentamt**

**European Patent Office**

**Office européen des brevets**

(19)

(11) Veröffentlichungsnummer : **0 337 194 B1**

(12) # EUROPÄISCHE PATENTSCHRIFT

(45) Veröffentlichungstag der Patentschrift :
**27.02.91 Patentblatt 91/09**

(51) Int. Cl.$^5$ : **H03H 7/21, H03H 7/48**

(21) Anmeldenummer : **89105566.7**

(22) Anmeldetag : **29.03.89**

(54) PI/2-Leistungsteiler.

(30) Priorität : **11.04.88 DE 3811986**

(43) Veröffentlichungstag der Anmeldung :
**18.10.89 Patentblatt 89/42**

(45) Bekanntmachung des Hinweises auf die
Patenterteilung :
**27.02.91 Patentblatt 91/09**

(84) Benannte Vertragsstaaten :
**DE FR GB**

(56) Entgegenhaltungen :
**EP-A- 0 126 169**

(56) Entgegenhaltungen :
**US-A- 3 267 358**
**US-A- 3 895 321**
**US-A- 4 254 386**
**MAGNETIC RESONANCE IN MEDICINE 1,**
**339-353 (1984)**

(73) Patentinhaber : **Siemens Aktiengesellschaft**
**Wittelsbacherplatz 2**
**D-8000 München 2 (DE)**

(72) Erfinder : **Oppelt, Ralph, Dr.**
**Lindenweg 1**
**D-8525 Uttenreuth (DE)**
Erfinder : **Vester, Markus**
**Pappelgasse 18**
**D-8520 Erlangen (DE)**

## Beschreibung

Die Erfindung bezieht sich auf einen PI/2-Leistungsteiler, der ein Eingangssignal aufteilt auf zwei Signalwege mit gleicher Amplitude und 90°-Phasenverschiebung, der vorzugsweise für die zirkular polarisierte Hochfrequenz-Antenne eines Kernspintomographen verwendet werden kann.

Es sind Geräte zum Erzeugen von Schnittbildern eines Untersuchungsobjektes, vorzugsweise eines menschlichen Körpers, mit magnetischer Kernresonanz bekannt. Diese sogenannten Kernspintomographen enthalten einen Grundfeld-Magneten, der die Kernspins im menschlichen Körper ausrichtet, und ferner Gradientenspulen, die ein räumlich unterschiedliches Magnetfeld erzeugen, und schließlich Hochfrequenzspulen zur Anregung der Kernspins und zum Empfang der von den angeregten Kernspins emittierten Signale. Beim Einsatz einer derartigen hochfrequenten Anregungs- und Meßspule wird die Induktivität der Spule zusammen mit einer veränderbaren Kapazität als LC-Resonanzkreis geschaltet, wobei dann die Kondensatoranordnung der gewünschten Frequenz entsprechend abgestimmt wird. Die Zuleitung enthält noch eine veränderbare Koppelkapazität zur Ankopplung des Resonators an einen Hochfrequenzgenerator der vorzugsweise ein Oszillator mit einem nachgeschalteten Sendeverstärker sein kann.

Im Gleichgewichtszustand ist die Magnetisierung der Kernspins parallel zum äußeren Magnetfeld ausgerichtet. Um ein verwertbares Signal zu erhalten, muß die Magnetisierung um 90° gedreht werden. Die Präzession der Kernspins nach dem 90°-Impuls bewirkt in einer Drahtschleife die Induktion eines Signals, dem sogenannten freien Induktionsabfall FID (free induction decay).

Da die kernspins mit einer mechanischen Präzessionsfrequenz im MHz-Bereich präzedieren, erzeugen sie in der Spule ein elektromagnetisches Wechselfeld. Das aufgenommene Hochfrequenzsignal wird über die Entkopplungsschaltung einem Detektor zugeführt. Als Entkopplungsschaltung kann ein Richtkoppler oder ein Schalter vorgesehen sein, der als Sende-und Empfangsweiche für die zugeführte und empfangene Leistung verwendet wird. Die magnetischen und elektrischen Hochfrequenzfelder verursachen im leitfähigen Körpergewebe des Patienten eine Hochfrequenzabsorption. Dies äußert sich in einer Verminderung der Resonanzgüte Q der Hochfrequenzspule. Ferner bewirken die elektrischen Eigenschaften des Körpergewebes eine Verminderung der Resonanzfrequenz beim Einbringen des Patienten in die Spule. Beide Effekte sind somit patientenabhängig und müssen vor jeder Aufnahme durch das sogenannte "Tuning and Matching" der Hochfrequenzspule korrigiert werden.

Zum Betrieb der Hochfrequenzspulen, insbesondere zirkular polarisierter Antennen, werden als Sende- und Empfangsweiche 3dB/90°-Hybride eingesetzt. Dabei wird bei ideal angepaßter Antenne das vom Sender in das Tor 1 des Richtkopplers eingespeiste Signal zu gleichen Leistungen auf die Tore 3 und 4 verteilt, diese Signale sind jedoch um 90° in der Phase gegeneinander verschoben. Am Empfängertor 2 tritt keine Hochfrequenzleistung aus, da die Tore 1 und 2 sowie 3 und 4 voneinander entkoppelt sind. Im Empfangsfall eilt das am Tor 4 entstehende Empfangssignal dem am Tor 3 entstehenden Signal auch wieder um 90° voraus. Beide Signale addieren sich somit phasenrichtig am Empfängertor 2, während am Sendertor 1 keine Leistung austritt (Taschenbuch der Hochfrequenztechnik, 4. Auflage, Band 1, 1986, Seiten L27-L35).

Die 3dB/90°-Hybride können in Leitungstecknik oder mit disktreten Bauelementen sowie als Mischversionen ausgeführt sein. In diesen Ausführungsformen ist die für die Kernspintomographie nutzbare Bandbreite sehr gering und beispielsweise nicht wesentlich mehr als 2%. Breitbandige Richtkoppler mit gekoppelten Leitungen würden bei niedrigen Frequenzen von beispielsweise etwa 10 MHz eine ungünstig große Leitungslänge erhalten. Will man beispielsweise bei einem Kernspintomographen verschiedene Atome untersuchen, beispielsweise Wasserstoff, Phosphor oder Natrium, d.h. bei verschiedenen Resonanzfrequenzen arbeiten, so ist für jede dieser Frequenzen ein dazugehöriges 3dB/90°-Hybrid erforderlich, das jeweils ausgetauscht oder in verhältnismäßig aufwendiger Weise umgeschaltet werden muß.

Der Erfindung liegt nun die Aufgabe zugrunde, ein 3dB/90°-Hybrid mit großer Bandbreite anzugeben.

Es sind Zwei-Phasen-Netzwerke bekannt mit der Eigenschaft an zwei Ausgangsklemmenpaaren über ein endliches Frequenzintervall zwei um einen konstanten Winkel gegeneinander verschobene Ausgangsspannungen zu erzeugen. Solche Netzwerke dienen dazu, zwei Ausgangssignale, die im genutzten Frequenzbereich gleiche Pegel und eine Phasendifferenz, beispielsweise 90°, aufweisen, zu erzeugen. Die beiden aufgespaltenen Signalwege enthalten jeweils eine Vierpolschaltung, die einen von der Frequenz unabhängigen Betrag des Übertragungsfaktors besitzt, einen sogenannten Allpaß. Im allgemeinen wird jeder Signalpfad eine Kette mehrerer Allpässe 1. oder 2. Ordnung enthalten (Nachrichtentechnik, Heft 5, 1957, Seiten 200 bis 205).

Es ist außerdem bekannt, daß sich ein Hochfrequenz-Differentialtransformator auch mit Leitungstransformatoren ausführen läßt (NTZ, 1966, Heft 9, Seiten 527 bis 538).

Es ist auch ein PI/2-Hybrid bekannt, das zur Ansteuerung der zirkular polarisierten Antenne eines Kernspintomographen mit einer Betriebsfrequenz von etwa 2,5 bis 8,2 MHz verwendet werden kann. Es enthält eine Reihenschaltung von zwei Trans formatoren mit unterschiedlichen Windungszahlen ihrer Primär- und Sekundärwicklungen, an deren Primärwicklungen ein Sender und ein Vorverstärker angeschlossen sind. Die Transformatoren sind mit geteilten Sekundärwicklungen versehen. An diese sind Allpaßglieder unterschiedlicher Dimensionierung angeschlossen, die gegenphasig angesteuert werden müssen (Magnetic Resonance in Medicine 1, 339-353 (1984)).

Die Erfindung beruht nun auf der Erkenntnis, daß ein zirkular polarisierter Betrieb des Kernspintomographen bei verschiedenen Resonanzfrequenzen, d.h. für verschiedene Atome, möglich ist, wenn eine breitbandige Entkopplungsschaltung zusammen mit einem 90°-Zwei-Phasen-Netzwerk verwendet werden. Die Erfindung besteht somit darin daß gemäß den kennzeichnenden Merkmalen des Anspruchs 1 eine Leitungstransformatoren enthaltende Entkopplungsschaltung kombiniert ist mit Allpaßnetzwerken und Impedanztransformatoren, die aus Leitungstransformatoren bestehen. Ist nur ein Sendebetrieb erforderlich, so kann die Entkopplungsschaltung aus einem Differentialtransformator oder auch aus einem Wilkinson-Leistungsteiler bestehen. Für Sende- und Empfangsbetrieb kann die Entkopplungsschaltung vorzugsweise aus einem breitbandigen 3dB/180°-Hybrid bestehen. Durch die Kombination des breitbandigen 3dB/180°-Hybrids als Leistungsteiler mit den Allpaßnetzwerken in zwei Signalwegen erhält man einen breitbandigen 3dB/90°-Richtkoppler, der insbesondere als Sende- und Empfangsweiche für zirkular polarisierte Hochfrequenz-Antennen eines Kernspintomographen in einem großen Frequenzbereich, insbesondere von mindestens 15 bis wenigstens 100 MHz, verwendet werden kann.

In der Ausführungsform mit einem 3-Tor als Entkopplungsschaltung, beispielsweise einem Wilkinson-Leistungsteiler, kann der breitbandige PI/2-Leistungsteiler beispielsweise in der Radartechnik zur Speisung von Sendeantennen oder auch zur Ansteuerung von Mischern sowie beispielsweise von Brückenverstärkern verwendet werden.

Zur weiteren Erläuterung der Erfindung wird auf die Zeichnung Bezug genommen, in deren

Figur 1 ein PI/2-Leistungsteiler gemäß der Erfindung mit einem 3-Tor als Entkopplungsschaltung schematisch veranschaulicht ist.

Figur 2 zeigt die Ausführung des 3-Tors als Wilkinson-Leistungsteiler. Gemäß

Figur 3 ist als Entkopplungsschaltung ein Differentialtransformator mit vorgeschaltetem Impedanztransformator vorgesehen. In den

Figuren 4 und 5 ist jeweils eine besondere Ausführungsform eines Differentialtransformators als Entkopplungsschaltung dargestellt.

Figur 6 zeigt eine besondere Ausführungsform des Allpaßnetzwerks. In

Figur 7 ist die gekoppelte Spule eines Allpaßnetzwerkes als Leitungstransformator veranschaulicht. Gemäß

Figur 8 ist als Entkopplungsschaltung ein breitbandiges 3dB/180°-Hybrid vorgesehen. In

Figur 9 ist ein breitbandiges 3dB/180°-Hybrid als Entkopplungsschaltung dargestellt.

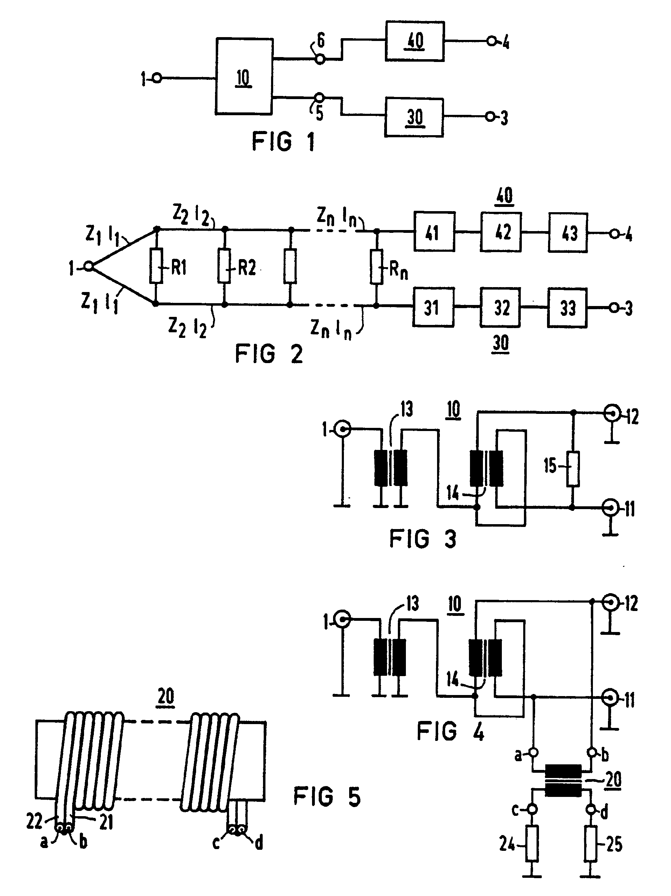

In der Ausführungsform eines PI/2-Leistungsteilers gemäß Figur 1 ist als Entkopplungsschaltung 10 ein 3-Tor vorgesehen, dessen Tor 1 an einen in der Figur nicht dargestellten Sender angeschlossen sein kann. Durch die Entkopplungsschaltung 10 wird ein Sendesignal am Tor 1 verzweigt, so daß an den Toren 5 und 6 zwei Signale gleicher Amplitude erscheinen und diese voneinander entkoppelt sind. Die beiden verzweigten Signalwege enthalten jeweils ein Allpaßnetzwerk 30 bzw. 40, so daß die Signale an den Toren 3 und 4 mit 90° Phasendifferenz erscheinen. Diese Ausführungsform des PI/2-Leistungsteilers ist beispielsweise für eine Sendeleistung von 1 kW im CW-Betrieb bzw. 15 kW Pulsleistung geeignet. Mit Leitungstransformatoren sowohl in der Entkopplungsschaltung 10 als auch in den Allpaßfilter ketten 30 und 40 erhält man in einem Frequenzbereich von beispielsweise 15 bis 86 MHZ in einem 50-Ohm-System eine maximale Amplitudendifferenz von nur etwa ± 1% und einen Phasenfehler von höchstens ± 1° sowie eine Durchgangsdämpfung pro Signalpfad von höchstens 3,01 + 0,3 dB.

Die Allpaßfilterketten 30 und 40 können beispielsweise jeweils ein Netzwerk mit mindestens einem Allpaß ersten Grades, vorzugsweise mehreren Allpässen ersten Grades pro Zweig, bilden, wobei 2 Allpässe 1. Grades zu einem Allpaß 2. Grades zusammengefaßt werden können. Solche Allpässe können beispielsweise jeweils aus einem Kreuzglied, sogenannten X-Gliedern, vorzugsweise aber aus überbrückten T-Gliedern, bestehen.

In der Ausführungsform des PI/2-Leistungsteilers gemäß Figure 2 ist als Entkopplungsschaltung 10 ein Wilkinson-Leistungsteiler vorgesehen, dessen Eingang 1 an einem Sender angeschlossen sein soll. Dem Eingang 1 ist über jeweils eine Leitung mit dem Wellenwiderstand $Z_1$ und der Länge $l_1$ ein Querwiderstand $R_1$ parallelgeschaltet. In der nächsten Stufe ist in gleicher Weise ein Querwiderstand R2 über jeweils eine Leitung mit dem Wellenwiderstand $Z_2$ und der Länge $l_2$ parallelgeschaltet. In dieser Ausführungsform der Entkopplungsschaltung 10 enthält der Wilkinson-Leistungsteiler vorzugsweise wenigstens eine, beispielsweise fünf Stufen, deren letzte Stufe über eine Leitung mit dem Wellenwiderstand $Z_n$ und der $l_n$ angeschlos-

sen ist. Die Querwiderstände $R_1$ bis $R_n$ dienen zur Entkopplung der beiden Tore 3 und 4. Die aufgetrennten Signalpfade enthalten jeweils eine Kette von beispielsweise drei Allpässen 1. Grades, die in der Figur mit 31 bis 33 bzw. 41 bis 43 bezeichnet sind und beispielsweise aus überbrückten T-Gliedern bestehen können. An den Ausgängen 3 und 4 erscheinen Signale mit gleicher Amplitude und 90°-Phasenverschiebung.

In der Ausführungsform gemäß Figur 3 ist eine Entkopplungs schaltung 10 dargestellt, die aus einem Differentialtransformator mit vorgeschaltetem Impedanztransformator besteht, deren Übertrager als Leitungstransformatoren ausgeführt sind. An das Tor 1 ist ein Sender angeschlossen und die Tore 11 und 12 sind jeweils mit einer Allpaß-Filterkette verbunden. Der dem Tor 1 nachgeschaltete Leitungstransformator 13 zur Impedanztransformation hat ein Übersetzungsverhältnis von annähernd $\sqrt{2} : 1$, beispielsweise 3 : 2. Der ebenfalls als Leitungstransformator ausgebildete Differentialtransformator 14 mit dem Übersetzungsverhältnis 1 : 1 ist dem Leitungstransformator 13 nachgeordnet. Dieser Transformator ist an die beiden Tore 11 und 12 angeschlossen. Zwischen diesen Toren ist ein Widerstand 15 mit der Größe des doppelten Wellenwiderstandes 2Z angeordnet. In dieser Ausführungsform der Entkopplungsschaltung 10 ergibt sich folgende Streumatrix

$$S = \frac{1}{\sqrt{2}} \cdot \begin{pmatrix} 0 & 1 & 1 \\ 1 & 0 & 0 \\ 1 & 0 & 0 \end{pmatrix}$$

wobei Tor 1 mit 1, Tor 2 mit 11 und Tor 3 mit 12 bezeichnet ist.

In der Ausführungsform einer Entkopplungsschaltung 10 gemäß Figur 4 mit dem Tor 1 und den Toren 11 und 12 sowie den Leitungstranformatoren 13 und 14 ist an die Tore 11 und 12 ein Hilfstransformator 20 angeschlossen, dessen beide Enden der Sekundärwicklung jeweils über einen Sumpf 24 bzw. 25 mit dem Wellenwiderstand Z an Masse gelegt sind. Dadurch kann der erdsymmetrische Widerstand der Impedanz 2Z, (15 in Fig. 3) durch zwei erdunsymmetrische Sümpfe 24 und 25, jeweils mit der Impedanz Z, ersetzt werden.

In der Ausführungsform gemäß Figur 5 kann der Hilfstransformator 20 vorzugsweise aus zwei Koaxialleitern 21 und 22 bestehen, die parallel zueinander angeordnet und auf einem gemeinsamen Kern 23 aufgewickelt sind. Von diesen beiden Koaxialleitern 21 und 22 mit der Impedanz Z sind die Enden a und b der Innenleiter an die Tore 11 und 12 der Entkopplungsschaltung 10 und die Enden c und d an die Sümpfe 24 und 25 gelegt und ihre Mäntel an beiden Enden miteinander verbunden.

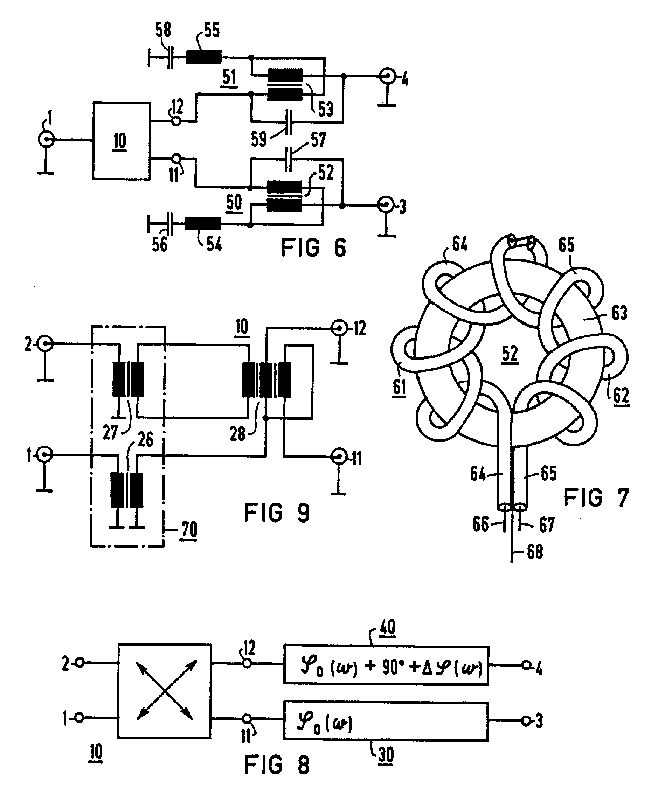

In der Ausführungsform eines PI/2-Leistungsteilers gemäß Figur 6 ist den Toren 11 und 12 der Entkopplungsschaltung 10 jeweils ein Allpaßnetzwerk 2. Grades 50 und 51 nachgeschaltet, die jeweils einen Leitungstransformator 52 bzw. 53, eine Induktivität 54 bzw. 55 sowie zwei Kapazitäten 56 und 57 bzw. 58 und 59 enthalten. In dieser Ausführungsform sind jeweils zwei Allpässe 1. Grades zu einem Allpaß 2. Grades zusammengefaßt. Allpässe 2. Grades haben gegenüber Allpässen 1. Grades den Vorteil, daß nichtideale Eigenschaften von Bauelementen, beispielsweise unzureichende Kopplung gekoppelter Spulen, schädliche Serieninduktivitäten von Kapazitäten und schädliche Parallelkapazitäten von Spulen bis zu einem gewissen Grade kompensiert werden können. Ferner benötigt man in dieser Ausführungsform weniger Bauelemente, was geringere Durchgangsverluste zur Folge hat.

Gemäß Figur 7 kann das Allpaßfilter 50 einen struktursymmetrischen Leitungsübertrager 52 enthalten, bei dem zwei Koaxialleiter 61 und 62 beispielsweise auf einem als Toroid gestalteten gemeinsamen Kern 63 aufgewickelt sind. Die Mäntel der beiden Koaxialleiter sind mit 64 bzw. 65 und die Innenleiter mit 66 bzw. 67 bezeichnet. Auf den oberen Enden dieser Koaxialleiter 61 und 62 ist der Innenleiter 66 des einen Koaxialleiters 61 mit dem Außenmantel 65 des anderen Koaxialleiters 62 verbunden und umgekehrt. Zwischen den Innenleitern 66 und 67 der unteren Enden liegt dann gemäß Figur 6 die Kapazität 57 und die elektrisch miteinander verbundenen beiden Mäntel 64 und 65 sind mit der Induktivität 54 verbunden. Die Mäntel 64 und 65 der Koaxialleiter 61 und 62 bilden einen gemeinsamen Anschluß 68. Durch die Überkreuzung an den oberen Enden der Koaxialleiter 61 und 62 erhält man einen völlig struktursymmetrischen Leitungstranformator.

In einer bevorzugten Ausführungsform des PI/2-Hybrides gemäß Figur 8 ist als Entkopplungsschaltung 10 ein breitbandes 3dB/180°-Hybrid vorgesehen, an dessen Tor 1 ein Sender und an dessen Tor 2 ein Empfänger angeschlossen sein kann. Dem Tor 11 ist eine Allpaß-Kettenschaltung nachgeschaltet, die am Tor 3 ein Ausgangssignal mit dem Phasenwinkel $\varphi_o(\omega)$ ergibt. Dem Tor 12 ist eine andere Allpaß-Kettenschaltung nachgeschaltet, die am Tor 4 ein Ausgangssignal mit dem Phasenwinkel $\varphi_o(\omega) + 90° + \Delta\varphi(\omega)$ ergibt.

In dieser Ausführungsform des PI/2-Hybrides erhält man eine breitbandige Sende- und Empfangsweiche, die vorzugsweise zum Betrieb einer zirkular polarisierten Antenne eines Kernspintomographen verwendet werden kann. In dieser Ausführungsform erhält man eine Streumatrix

$$S = \frac{e^{j\,\vartheta_0(\omega)}}{\sqrt{2}} \cdot \begin{pmatrix} 0 & 0 & 1 & j\delta \\ 0 & 0 & -1 & j\delta \\ 1 & -1 & 0 & 0 \\ j\delta & j\delta & 0 & 0 \end{pmatrix}$$

Im Idealfall verschwindet der Phasenrestfehler $\Delta\varphi(\omega)$, d.h.

$$\delta = e^{j\Delta\varphi(\omega)} \to 1$$

Gemäß Figur 9 kann als Entkopplungsschaltung 10 ein als Leitungstransformator ausgebildeter Differentialtransformator 28 vorgesehen sein, der zusammen mit zwei weiteren Leitungstransformatoren 26 und 27 ein breitbandiges 3 dB/180°-Hybrid bildet. An das Tor 1 soll wieder ein Sender und an den Eingang 2 ein Empfänger angeschlossen sein. Die Tore 11 und 12 sind jeweils mit einer Allpaßfilterkette verbunden. Das Tor 1 ist mit dem Leitungstransformator 26 und das Tor 2 mit dem Leitungstransformator 27 verbunden. Diese Eingangstransformatoren haben jeweils ein Übersetzungsverhältnis von wenigstens annähernd $\sqrt{2}$ : 1, beispielsweise 3 : 2 und wirken dadurch als Impedanztransformator 70. Der Differentialtransformator 28 hat ein Übersetzungsverhältnis 1 : 1 : 1. Die bieden nicht näher bezeichneten Sekundärwicklungen sind jeweils an eines der Tore 11 und 12 angeschlossen. In dieser Ausführungsform des 3 dB/180°-Hybrids 10 erhält man eine Streumatrix

$$S = \frac{1}{\sqrt{2}} \cdot \begin{pmatrix} 0 & 0 & 1 & 1 \\ 0 & 0 & -1 & 1 \\ 1 & -1 & 0 & 0 \\ 1 & 1 & 0 & 0 \end{pmatrix}$$

In dieser Ausführungsform sind alle Transformatoren als Leitungstransformatoren ausgebildet, wodurch man eine große Bandbreite erhält.

## Ansprüche

1. PI/2-Leistungsteiler, der ein Eingangssignal aufteilt in zwei Signalwege mit gleicher Amplitude und 90°-Phasenverschiebung, **gekennzeichnet** durch folgende Merkmale :
   a) Der Leistungsteiler enthält eine Entkopplungsschaltung (10), die wenigstens einen Leitungstransformator enthält,
   b) dieser Entkopplungsschaltung (10) sind erdunsymmetrische Allpaßnetzwerke (30, 40) zugeordnet, die aus Leitungstransformatoren bestehen (Figur 1).

2. PI/2-Leistungsteiler nach Anspruch 1, **dadurch gekennzeichnet,** daß als Entkopplungsschaltung (10) ein Wilkinson-Leistungsteiler vorgesehen ist (Figur 2).

3. PI/2-Leistungsteiler nach Anspruch 1, **dadurch gekennzeichnet,** daß die Entkopplungsschaltung (10) einen Differentialtransformator (14) mit einem Übersetzungsverhältnis 1 : 1 enthält, dem als Impedanzwandler ein Leitungstransformator (13) mit einem Spannungsübersetzungsverhältnis von wenigstens annähernd $\sqrt{2}$ : 1 vorgeschaltet ist und daß zwischen den Ausgängen (11, 12) ein Widerstand (15) mit der Größe des doppelten Wellenwiderstands 2Z angeordnet ist (Figur 3).

4. PI/2-Leistungsteiler nach Anspruch 3, **dadurch gekennzeichnet,** daß an die Ausgänge (11, 12) ein Hilfstransformator (20) angeschlossen ist, an den zwei Sümpfe (24, 25) mit der Impedanz des Wellenwiderstandes Z angeschlossen sind (Figur 4).

5. PI/2-Leistungsteiler nach Anspruch 4, **gekennzeichnet** durch zwei koaxiale Sümpfe (24, 25).

6. PI/2-Leistungsteiler nach Anspruch 4 oder 5, **dadurch gekennzeichnet,** daß der Hilfstransformator (20) aus Koaxialleitungen mit der Impedanz Z besteht, die parallel zueinander auf einem gemeinsamen Kern (23) aufgewickelt sind (Figur 5).

7. PI/2-Leistungsteiler nach einem der Ansprüche 1 bis 6, **dadurch gekennzeichnet,** daß die Allpaßfilterketten (30, 40) jeweils mindestens einen Allpaß ersten oder zweiten Grades enthalten, die jeweils einen Leitungstransformator (52 bzw. 53) enthalten (Figur 6).

8. PI/2-Leistungsteiler nach einem der Ansprüche 1 bis 7, **dadurch gekennzeichnet,** daß die Allpässe mit struktursymmetrischen Leitungstransformatoren (52) vorgesehen sind (Figur 7).

9. PI/2-Leistungsteiler nach Anspruch 8, **dadurch gekennzeichnet,** daß zwei Koaxialleiter (61, 62) gleicher Länge über Kreuz miteinander verbunden sind, derart, daß an den oberen Enden der Mantel (64) des einen Koaxialleiters (61) mit dem Innenleiter (67) des anderen Koaxialleiters (62) verbunden ist und umgekehrt, und daß die beiden Koaxialleiter (61, 62) auf einem Kern (63) angeordnet sind und daß die beiden Mäntel (64, 65) der Koaxialleiter (61, 62) einen gemeinsamen Anschluß (68) bilden (Figur 7).

10. PI/2-Leistungsteiler nach einem der Ansprüche 1 bis 9, **dadurch gekennzeichnet,** daß der Entkopplungsschaltung (10) ein Impedanzwandler (70) vorgeschaltet ist (Figur 9).

11. PI/2-Leistungsteiler mit der Streumatrix

$$S = \frac{e^{j\varphi_0(\omega)}}{\sqrt{2}} \cdot \begin{pmatrix} 0 & 0 & 1 & j^\delta \\ 0 & 0 & -1 & j^\delta \\ 1 & -1 & 0 & 0 \\ j^\delta & j^\delta & 0 & 0 \end{pmatrix}$$

und $\delta = e^{j\Delta\varphi(\omega)}$, **gekennzeichnet** durch folgende Merkmale :

a) Als Entkopplungsschaltung (10) ist ein breitbandiges 3dB/180°-Hybrid mit einem Sendetor 1, einem Empfangstor 2 und zwei Ausgangstoren 11 und 12 vorgesehen, das einen als Leitungstransformator ausgebildeten Differentialtransformator (28) enthält,

b) dem Sendetor 1 und dem Empfangstor 2 ist jeweils ein als Leitungstransformator ausgebildeter Impedanzwandler (26 bzw. 27) nachgeschaltet,

c) den Ausgangstoren 11 und 12 ist jeweils eine erdunsymmetrische Allpaßkettenschaltung (30, 40) nachgeschaltet, die Leitungstransformatoren enthalten,

d) eine der Allpaßkettenschaltungen (30) erzeugt einen Phasengang $\varphi_0(\omega)$,

e) die andere Allpaßkettenschaltung (40) erzeugt einen Phasengang $\varphi_0(\omega) + 90° + \Delta\varphi(\omega)$.

12. PI/2-Leistungsteiler nach Anspruch 11, **dadurch gekennzeichnet,** daß das Spannungsübersetzungsverhältnis der Impedanzwandler (26, 27) jeweils etwa $\sqrt{2}$. 1 beträgt.

13. PI/2-Leistungsteiler nach Anspruch 11, **dadurch gekennzeichnet,** daß das Spannungsübersetzungsverhältnis der Impedanzwandler (26, 27) jeweils 3 : 2 beträgt.

## Claims

1. PI/2 power divider which divides an input signal into two signal paths having equal amplitude and 90° phase shift, characterised by the following features :

a) the power divider contains a decoupling circuit (10) which contains at least one line transformer,

b) there are assigned to this decoupling circuit (10) unbalanced-to-earth all-pass networks (30, 40) which consist of line transformers (Figure 1).

2. PI/2 power divider according to claim 1, characterised in that a Wilkinson power divider is provided as decoupling circuit (10) (Figure 2).

3. PI/2 power divider according to claim 1, characterised in that the decoupling circuit (10) contains a differential transformer (14) having a transformation ratio of 1 : 1, to which there is previously connected as impedance converter a line transformer (13) with a voltage transformation ratio of at least approximately $\sqrt{2} : 1$ and in that a resistor (15) with the magnitude of twice the characteristic wave impedance 2Z is arranged between the outputs (11, 12) (Figure 3).

4. PI/2 power divider according to claim 3, characterised in that there is connected to the outputs (11, 12) an auxiliary transformer (20) to which two sinks (24, 25) with the impedance of the characteristic wave impedance Z are connected (Figure 4).

5. PI/2 power divider according to claim 4, characterised by two coaxial sinks (24, 25).

6. PI/2 power divider according to claim 4 or 5, characterised in that the auxiliary transformer (20) consists of coaxial lines with the impedance Z, wound up parallel to each other on a common core (23) (Figure 5).

7. PI/2 power divider according to one of the claims 1 to 6, characterised in that each of the allpass filter chains (30, 40) contains at least one allpass of the first or second degree, each of which contains a line transformer (52 or 53 respectively) (Figure 6).

8. PI/2 power divider according to one of the claims 1 to 7, characterised in that the all-passes are provided with structure-symmetrical line transformers (52) (Figure 7).

9. PI/2 power divider according to claim 8, characterised in that two coaxial conductors (61, 62) of equal length are connected with each other in diagonally opposite sequence such that at the upper ends the casing (64) of the one coaxial conductor (61) is connected with the internal conductor (67) of the other coaxial conductor (62) and vice versa and in that the two coaxial conductors (61, 62) are arranged on a core (63) and in that the two casings (64, 65) of the coaxial conductors (61, 62) form a common correction (68) (Figure 7).

10. PI/2 power divider according to one of the claims 1 to 9, characterised in that an impedance converter (70) is previously connected to the decoupling circuit (10) (Figure 9).

11. PI/2 power divider having the scattering matrix

$$S = \frac{e^{j\varphi_0(\omega)}}{\sqrt{2}} \cdot \begin{matrix} 0 & 0 & 1 & j^\delta \\ 0 & 0 & -1 & j^\delta \\ 1 & -1 & 0 & 0 \\ j^\delta & j^\delta & 0 & 0 \end{matrix}$$

and $\varphi = e^{j\Delta\varphi(\omega)}$ characterised by the following features :

a) there is provided as decoupling circuit (10) a wide-band 3db/180° hybrid which has a send gate (1), a receive gate (2) and two output gates (11 and 12) and contains a differential transformer (28) formed as a line transformer,

b) an impedance converter (26 and 27 respectively) formed as a line transformer is subsequently connected to the send gate (1) and to the receive gate (2) respectively,

c) an unbalanced-to-earth all-pass chain circuit arrangement (30 and 40 respectively) is subsequently connected to one respective output gate (11 and 12), the chain circuit arrangements each containing at least one line transformer,

d) one of the all-pass chain circuit arrangements (30) generates a phase response $\varphi_0(\omega)$.

e) the other all-pass chain circuit arrangement (40) generates a base response $\varphi_0(\omega) + 90° + \Delta\varphi(\omega)$.

12. PI/2 power divider according to claim 11, characterised in that the voltage transformation ratio of the impedance converters (26, 27) amounts, in each case, to approximately $\sqrt{2} : 1$.

13. PI/2 power divider according to claim 11, characterised in that the voltage transformation ratio of the impedance converters (26, 27) amounts, in each case, to 3 : 2.


## Revendications

1. Diviseur de puissance PI/Z qui répartit un signal d'entrée en deux voies de signaux de même amplitude et à déphasage de 90°, caractérisé par les particularités suivantes :

a) le diviseur de puissance comprend un circuit de découplage (10) comportant au moins un transformateur de ligne,

b) à ce circuit de découplage (10) sont associés, avec symétrie par rapport à la terre des réseaux passe-tout (30, 40) qui sont constitués par des transformateurs de ligne.

2. Diviseur de puissance PI/2 selon la revendication 1, caractérisé par le fait que l'on prévoit, en temps que circuit de découplage (10) un diviseur de puissance de WILKINSON (fig 2).

3. Diviseur de puissance PI/2 selon la revendication 1, caractérisé par le fait que le circuit de découplage (10) comporte un transformateur différentiel (14) avec en rapport de transformation 1 : 1, en amont duquel est prévu, en temps que transformateur d'adaptation d'impédance, un transformateur de ligne (13) à rapport de transformation de la tension d'au moins approximativement √2 : 1, et qu'entre les sorties (11, 12) est disposée une résistance (15) d'une valeur qui est égale au double de l'impédance caractéristique (22) (fig 3).

4. Diviseur de puissance PI/2 selon la revendication 3, caractérisé par le fait qu'aux sorties (11, 12) est relié à un transformateur auxiliaire (20) auxquelles sont reliées deux résistances (24, 25) ayant l'impédance de l'impédance caractéristique Z (fig 4).

5. Diviseur de puissance PI/2 selon la revendication 4, caractérisé par deux résistances coaxiales (24, 25).

6. Diviseur de puissance PI/2 selon la revendication 4 ou 5, caractérisé par le fait que le transformateur auxilliaire (20) est constitué par des conducteurs coaxiaux d'impédance Z, qui sont enroulés parallèlement entre eux sur un noyau commun (23) (fig 5).

7. Diviseur de puissance PI/2 selon l'une des revendications 1 à 6, caractérisé par le fait que les chaînes de filtres passe-tout (30, 40) comportent chacune au moins un passe-tout du premier ordre ou du second ordre et qui comporte respectivement un transformateur de ligne (52, 53) (fig 6).

8. Diviseur de puissance PI/2 selon l'une des revendications 1 à 7, caractérisé par le fait que les passetout sont pourvus de transformateurs de ligne à structure symétrique (52) (fig 7).

9. Diviseur de puissance PI/2 selon la revendication 8, caractérisé par le fait que deux conducteurs coaxiaux (61, 62) de même longueur sont reliés entre eux et en croix de façon qu'aux extrémités supérieures l'enveloppe (64) de l'un des conducteurs coaxiaux (61) est reliée au conducteur intérieur (67) de l'autre conducteur coaxial (62), et inversement, et par le fait que les deux conducteurs coaxiaux (61, 62) sont disposés sur un noyau (63) alors que les deux enveloppes (64, 65) des conducteurs coaxiaux (61, 62) forment un raccordement commun (68) (fig 7).

10. Diviseur de puissance PI/2 selon l'une des revendications 1 à 9, caractérisé par le fait qu'en amont du dispositif de découplage (10) est prévu un transformateur d'adaptation d'impédance (70) (fig 9).

11. Diviseur de puissance PI/2 à matrice de commande

$$S = \frac{e^{j\Psi_0(\omega)}}{\sqrt{2}} \begin{array}{cccc} 0 & 0 & 1 & j^\delta \\ 0 & 0 & -1 & j^\delta \\ 1 & -1 & 0 & 0 \\ j^\delta & j^\delta & 0 & 0 \end{array}$$

Et $\delta = e^{j\Delta\varphi(\omega)}$

caractérisé par les particularités suivantes :

a) en tant que circuit de découplage (10) il est prévu un circuit hibryde à bande large de 3dB/180°, avec une porte d'émission 1, une porte de réception 2 et deux portes de sorties 11 et 12, lequel circuit hybride comporte un transformateur différentiel (28) réalisé sous la forme d'un transformateur de ligne,

b) en aval de la porte d'émission 1 et de la porte de réception 2 sont prévus respectivement un transformateur d'adaptation d'impédance (26, 27), réalisé sous la forme d'un transformateur de ligne,

c) en aval des portes de sorties 11 et 12 sont respectivement prévus des réseaux itératifs ou passes-tout asymétrie par rapport à la terre (30, 40), qui comportent les transformateurs de lignes,

d) l'un des réseaux itératif de passe-tout (30) $\varphi_0(\omega)$,

e) l'autre circuit itératif passes-tout (40) produit ne réponse $\varphi_0(\omega) + 90° + \Delta\varphi(\omega)$.

12. Diviseur de puissance PI/2 selon la revendicaion 11, caractérisé par le fait que le rapport de transforation de la tension des transformateurs d'adaptation impédance (26, 27) est, respectivement, d'environ √2 : 1.

13. Diviseur de puissance PI/2 selon la revendication 11 caractérisé par le fait que le rapport de transformation de tension des transformateurs d'adaptation d'impédance (26, 27) est respectivement 3 : 2.

FIG 1

FIG 2

FIG 3

FIG 4

FIG 5

FIG 6

FIG 7

FIG 9

$$\mathscr{S}_0(w) + 90° + \Delta\mathscr{S}(w)$$

$$\mathscr{S}_0(w)$$

FIG 8